# EUROPEAN PATENT APPLICATION

(11) **EP 1 478 014 A1**
(43) Date of publication of application: **17.11.2004**
(21) Application number: 03076445.0
(22) Date of filing: 13.05.2003
(51) Int. Cl.: H01L 21/48, H01L 21/00

(54) **Improved production method for QFN leadframes**

(71) Applicant: Perspa b.v., 5047 TS Tilburg (NL)
(72) Inventor: Rullens, Antonie Petrus, 5047 TS Tilburg (NL)

(57) **Abstract**

The invention relates to an improved punching process, by means of which a matrix of leadframes to be included in a Quad Flat Non-leaded (QFN) package is produced. A punching tool, comprising a bottom plate (2), a die plate (3), a guide plate (4), a supporting plate (7), cutters (8), an ejector nipple (12) and a coin punch (17) is also disclosed.

## Description

The present invention relates to a method and apparatus for for manufacturing QFN-leadframes (= Quad Flatpackage No-leadframes), for mounting chips or Integrated Circuits (IC's) by means of bonding on mentioned QFN-leadframes, after which the whole is transformed into a package by means of moulding, in which mentioned QFN-leadframes can be made from a copper strip from a roll with a thickness of approximately 0.15 mm and a width of approximately 57 mm.

QFN-leadframes or QUAD Flatpackage No-leadframes are the latest developments in the construction of semiconductor products in package shape, in which a reduction in dimensions of up to 62% in comparison with equivalent TSSOP-packages is possible.

The production of a semiconductor product in the shape of a package is roughly carried out as follows: The production of QFN-leadframes, after which the IC-assembly takes place is followed by so-called "bonding", in which the lead of the QFN-leadframe and IC-contacts are connected by means of golden wires and finally the "moulding" to a package takes place.

At this moment etching is used to produce QFN-leadframes, which involves a significant anti-pollution tax or costs of treating the waste water. On a global scale it involves very large numbers, i.e. billions per month, which for reasons of environmental pollution raises many objections against the etching-process.

In addition, the QFN-leadframes must be produced very flatly and with almost no burrs or deformations, as a result of which a mechanical loading of the QFN-leadframes is not feasible during the process of progressive sequential punching because e.g. the leads could be twisted and could show a burr.

Because of the design of the QFN-leadframes is punching or die cutting them a challenge. Well known devices in package form, such as TSSOP's and SOIC's are connected with the printed circuit board (PCB) by means of wires or leads, which protrude from the side of the package, by means of soldering onto the PCB (in fact, a huge amount of lead is used).

In case of QFN-leadframes, the electronic connection with the PCB is located at the bottom of the package. To enable a surface assembly of the package with IC with PCB, the flatness or straightness of the wires or leads is a critical factor with this type of design.

Standard progressive punching tools, which are used in accordance to the state of the art, punching does not occur simultaneously but sequentially, as a result of which due to the cutting, the parts and especially the "leads" of the QFN-frame can be twisted and provided with burrs, through which mentioned QFN-leadframes cannot meet the severe or tringent demands of flatness.

In short, the known method to use progressive punching machines show a number of disadvantages, in order to achieve a required standard of quality in manufacturing the QFN-leadframes.

It is the object of the present invention to provide an improved manufacturing method or process for QFN-leadframes by using punching tools, which do not show aforementioned disadvantages and with which QFN-leadframes can be manufactured in large numbers and have the required quality standard of lead flatness.

For this a manufacturing process and apparatus for manufacturing QFN-leadframes is developed in a very inventive way, characterized in that, the mentioned QFN-leadframes can be shaped as a one-hit system during a number of processes or phases by means of a punch or die cut process from mentioned copper strip from the roll, through which an n x n matrix of QFN-leadframes is successively created, in which the punching or die cut for forming the mentioned QFN-leadframes is placed as a plate package in special punching or die cut tools in machines used in practice, in which the mentioned quantity of processes or phases consists of a first phase with a cutter with a cut over a part of the strip thickness followed by further punching out and partly pushing back the punched out parts or slugs, a second phase in which the mentioned strip is meanwhile shifted and in which then by means of an ejector the mentioned punched out parts or slugs are punched out as waste, after which the strip is shifted further and in a third phase bearded parts on the leads are formed with a coin punch with cutting edges in the direction of the thicker side of the processed strip in order to be used later as locks in the moulding of plastic of the total package, in which the mentioned processes or phases are constantly successively executed as one-hit in the plate package of the punching tools, in which punching tools are constructed of hardened material, in which the successive plate-shaped parts of the plate package of the punching tools are form retaining and the thickness dimensions of the mentioned plate-shaped parts are adjustable to the client's machines used.

The advantage is an environmentally friendly punched n x n matrix of QFN-leadframes, which can be produced in three phases according to the one-hit system. No environmental pollution occurs when producing large quantities of IC's in package format, such as at the etching-process. Further herewith a QFN-leadframe can be manufactured with a perfect flat bottom side without burrs, etc.

Further, the work method according to the invention is further developed in such a way that, in the mentioned first phase the cutting over approximately 1/3 of the strip thickness is executed and punching out of the so-called piercing slugs over the remaining or 2/3 of the strip thickness and the pushing back with a spring loaded ejector up to approximately 2/3 of the strip thickness, and that in the mentioned second phase the punched out parts or slugs are transported by the mentioned plate package of the punching tool, and that in the mentioned third phase the leads are flattened and are provided with locks by means of a so-called coin process, in which near the end of the leads these are cut over approximately half of the strip thickness to form in this way with the punched forward material, the lock when it is later moulded into a package.

The advantages are a perfect design, dimensions and construction of the QFN-leadframes.

Furthermore the invention, constructed as punching tools for executing the work method as claimed in claims 1 up to 4 according to the invention is further surprisingly developed, characterized in that, the mentioned punching tools from the bottom to the top are constructed of a plate package with plate thicknesses which are adjustable to machines used in practice, in which the mentioned plate package consists of a bottom plate, a die or coin plate, a guide plate, a supporting plate for the cutter or the nipple and a top plate, in which the mentioned copper strip from the roll between the die and coin plate is lead through, in which the cutter, the ejector and the coin punch are suitably moveable over a vertical distance.

The advantages are punching tools, which can be produced quickly and meet the high standards.

Furthermore the apparatus according to the invention is further developed in such a way, that the cutting parts of the mentioned cutter can be made of a ceramic material.

The advantage is a very durable embodiment of the cutting parts.

The preferred construction of the invention will be described by way of example, and with reference to the accompanying drawing.

In which:
- Fig. 1: shows a schematic vertical cross-section over the plate package of the punching tools illustrating the first phase of the punching process of the QFN-leadframes according to a preferred embodiment of the invention;
- Fig. 2: ditto as figure 1 but now illustrating the second phase of the punching process of the QFN-leadframes;
- Fig. 3: ditto as figure 1 but now illustrating the third phase of the punching process of the QFN-leadframes and again according to a preferred embodiment of the invention;
- Fig. 4: shows a top view of the QFN-leadframe from an n x n matrix according to the invention; and
- Fig. 5: shows a cross-section over the line V-V of the leads of figure 4.

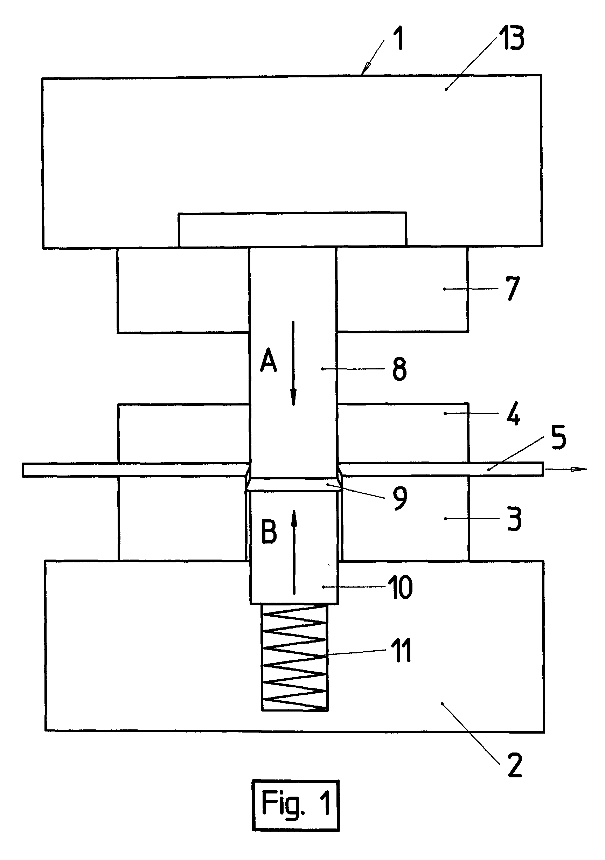

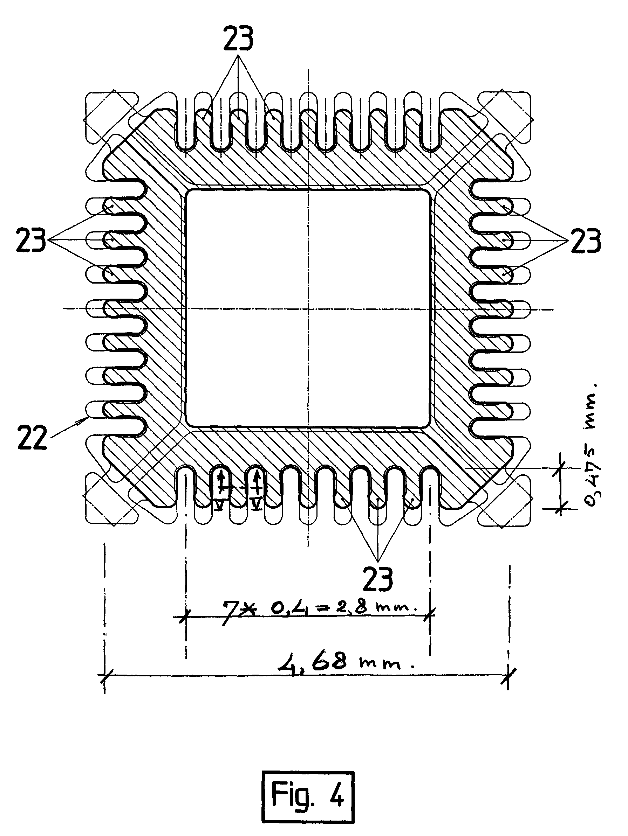

Figure 1 schematically shows a vertical cross-section of the plate package 1 of the punching tools, in which the cross-section is taken over the part to execute the first phase. The plate package 1 from the bottom to the top, is built-up from a bottom plate 2, a die or coin plate 3 and on top of that a guide plate 4. Between the die or coin plate 3 and the guide plate 4 copper strip 5 to be processed is situated to create an n x n matrix of QFN-leadframes 6 (see figure 4).

The cutter 8 is mounted onto the support plate 7 which, together with top plate 13, is moveable at a suitable vertical distance indicated with arrow A. The slugs 9 of the copper strip 5 are detained by the ejector 10 with spring 11 for pushing back over a certain distance indicated by arrow B.

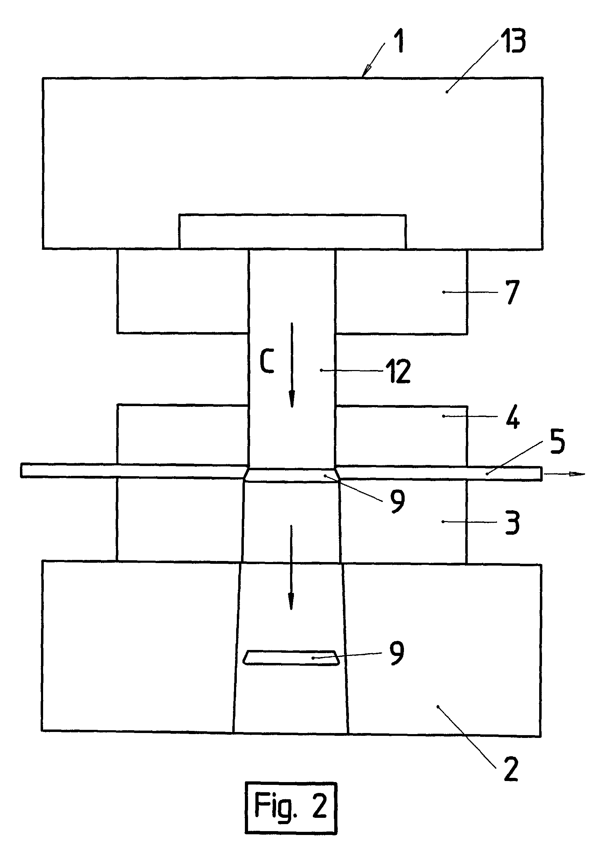

Figure 2 shows a cross-section over phase 2, in which removing the slugs 9 or waste is done with the ejector 12. The ejector 12 is moveable at a vertical distance indicated with arrow C.

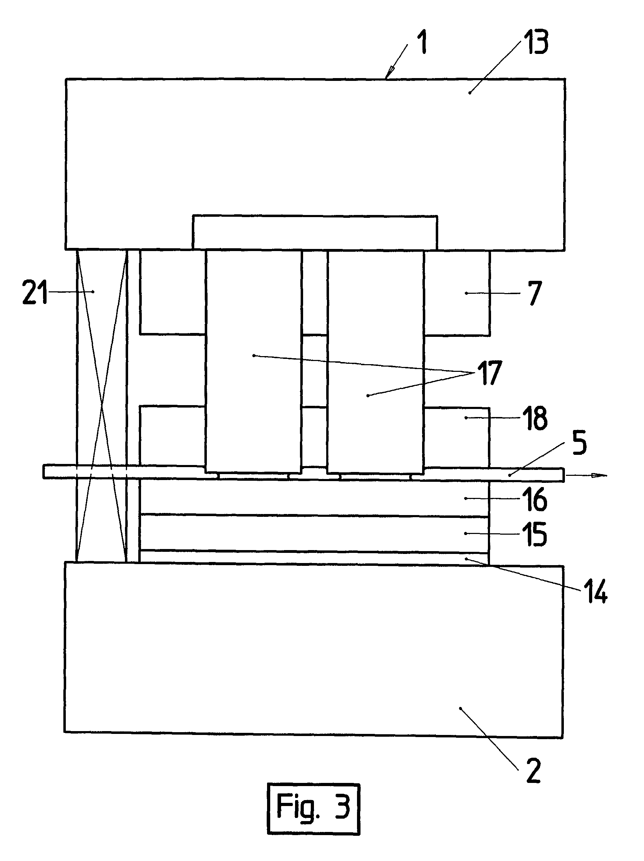

Figure 3 shows a cross-section of phase 3. Now, above the bottom plate 2, a pressure plate 14 with filling plate 15 and coin plate 16 are applied for flatting the formed QFN-leadframes into the copper strip 5 with the coin punches 17.

The coin punch 17 is guided by a stripper 18. Further the coin punch consists of a further support plate 19, buffer plate 20 and then again the top plate 13. The vertical movement space is adjusted with the stop block 21.

Figure 4 shows in top view schematically a QFN-leadframe 22 with the leads 23.

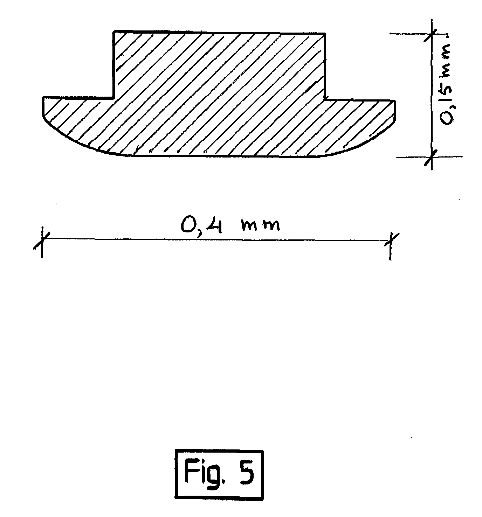

Figure 5 shows a final cross-section over the leads 23 of figure 4 in the final form, in which these leads anchor well in the moulding.

Finally it has to be emphasized, that the above description constitutes a preferred embodiment of the invention, but that further variations and modifications are still possible without departing the scope of this patent document.

## Claims

1. Method or process for manufacturing QFN-leadframes (= Quad Flatpackage No-leadframes), for mounting thereon chips or Integrated Circuits (IC's) by means of bonding, after which the whole is transformed into a package by means of moulding, in which mentioned QFN-leadframes can be made from a copper strip from a roll with a thickness of approximately 0.15 mm and a width of approximately 57 mm, **characterized in that**, the mentioned QFN-leadframes (22) can be shaped as a one-hit system during a number of processes or phases by means of a punch or die cut process from mentioned copper strip (5) from the roll, through which an n x n matrix of QFN-leadframes is successively created, in which the punching or die cut for forming the mentioned QFN-leadframes (22) is placed as a plate package in special punching or die cut tools in machines used in practice, in which the mentioned quantity of processes or phases consists of a first phase with a cutter (8) with a cut over a part of the strip thickness followed by further punching out and partly pushing back the punched out parts or slugs (9), a second phase in which the mentioned strip is meanwhile shifted and in which then by means of an ejector (12) the mentioned punched out parts or slugs (9) are punched out as waste, after which the strip (5) is shifted further and in a third phase bearded parts on the leads (23) are formed with a coin punch (17) with cutting edges in the direction of the thicker side of the processed strip (5) in order to be used as locks when later the plastic of the total package is moulded, in which the mentioned processes or phases are constantly successively executed as one-hit in the plate package of the punching tools, in which punching tools are constructed of hardened material, in which the successive plate-shaped parts of the plate package (1) of the punching tools are form retaining and the thickness dimensions of the mentioned plate-shaped parts are adjustable to the machines used by the client.

2. Method as claimed in claim 1, **characterized in that**, in the mentioned first phase the cutting over approximately 1/3 of the strip thickness is executed and punching out of the so-called piercing slugs (9) over the remaining or 2/3 of the strip thickness and the pushing back with a spring loaded ejector (10) up to approximately 2/3 of the strip thickness.

3. Method as claimed in claim 1, **characterized in that**, in the mentioned second phase the punched out parts or slugs (9) are transported by the mentioned plate package (1) of the punching tool.

4. Method as claimed in claim 1, **characterized in that,** in the mentioned third phase the leads (23) are flattened and are provided with locks by means of a so-called coin process, in which near the end of the leads these are cut over approximately half the strip thickness to form in this way with the punched forward material, the lock when it is later moulded into a package.

5. Apparatus constructed as punching tools for executing the work method as claimed in claims 1 -5, **characterized in that**, the mentioned punching tools from the bottom to the top are constructed of a plate package (1) with plate thicknesses which are adjustable to machines used in practice, in which the mentioned plate package consists of a bottom plate (2), a die or coin plate (3, 16), a stripper (3), a supporting plate (7) for the cutter (8) or the nipple (12) and a top plate (13), in which the mentioned copper strip (5) from the roll between the die and coin plate (3, 4) is lead through, in which the cutter (8), the ejector (12) and the coin punch (17) are suitably moveable over a vertical distance.

6. Apparatus as claimed in claims 1 and 5, **characterized in that,** the cutting parts of the mentioned cutter (8) can be made of a ceramic material.

7. Apparatus as claimed in claims 1, 5 and 6, **characterized in that,** with the mentioned punching tools an n x n matrix of QFN-leadframes (22) are punchable, in which n can have value 8, so that 64 QFN-leadframes, on the spot, in the copper strip (5) are created.

8. Apparatus as claimed in claims 1 and 5, **characterized in that**, the material of the punching tools is a hardened steel, such as 1.2767 steel.

## Amended claims

### Amended claims in accordance with Rule 86(2) EPC.

**1.** Procedure of the manufacturing of QFN-leadframes (= Quad Flat No-Leadframes), for the attachment of chips or integrated circuits (ICs) by bonding, after which it will be completed to a package by injection moulding, in addition the particular QFN-leadframes could be made from a copper strip from the coil with a thickness of e.g. 0,15 mm and a width of approximately 57 mm, **characterised in that**, these QFN-Leadframes (22) could be formed by a stamping process from the copper strip of the coil in a number of stampings or phases in a one-hit system, so that an n x n matrix of QFN-Leadframes in the strip is created in a sequential order, taking into account that stamping in order to form the QFN-Leadframes in a specific stamping tool will be placed as a stack of plates in a regular stamping machine from which the number of treatments or phases mentioned earlier exists from the first phase with a punch (8), which will only cut a part of the strips' thickness followed by a through-and-through cut and a pushing back of the punched part (9), in which the second phase, from which said strip is transferred by one pitch, which by means of a press punch punches the partly cutted pieces, which will be pushed out of the strip, followed by a subsequent transfer (pitch) and in this situation the coin punch (17) will coin the plastic locks on the leads (23), which in a later stadium will have the function to lock the leads in the synthetic material of the total package from which the said treatment will be carried out as a one-hit system in the stack of plates in the stamping tool, in which the cutting and coining parts are made from carbide in addition to which the sequential plate parts from the stack of plates (1) from the stamping tool are being defined and the thicknesses of the parts are adjustable in the regular machines.

**2.** Procedure according to claim 1, **wherein,** in mentioned first phase, the cutting has taken place over 1/3 of the thickness of the strip and the final cut-out from the slug (9) over the remaining 2/3 of the thickness of the strip and pushing it in return with a springloaded ejector (10) until this has reached 2/3 of the thickness of the strip.

**3.** Procedure according to claim 1, **wherein,** in mentioned second phase, the cutted parts or slugs are released from the stamping tool through said stack of plates.

**4.** Procedure according to claim 1, **wherein,** in mentioned third phase, the leads (23) are being coined and will get their locks by coining the tips of the leads by cutting them to half the size of the material thickness to form the lock, so it can be moulded into a package.

**5.** Apparatus configured as a stamping tool to execute the procedure according to claims 1 up to 4, **characterised in that**, mentioned stamping tool from top to bottom is built-up in a stack of plates comprising a bottom plate (2), a punch holder plate (7) for the punches (8) or punch (12) and a top plate (13), from which the (copper) strip (5) can be fed from a coil between the cutting plate (3) and the guide plate (4) from which the punch (8), the press punch (12) and the coin punch (17) can be moved perpendicularly in a suitable way.

**6.** Procedure according to claims 1-5, wherein, the cutting parts from said punch could be made from a ceramic material.

**7.** Procedure according to claims 1, 5 and 6, wherein, a n x n matrix of QFN-Leadframes (22) can be stamped with said stamping tool, in which n could have value 8, so that 64 QFN-frames are created in the copper strip.

**8.** Procedure according to claims 1 to 5, wherein, the material of the stamping tool consists of a hardened steel, e.g. 1.2767 steel.
